# EUROPEAN PATENT APPLICATION

(11) **EP 4 564 016 A1**
(43) Date of publication of application: **04.06.2025**
(21) Application number: 23383238.5
(22) Date of filing: 30.11.2023
(51) Int. Cl.: G01R 15/22, G01R 19/165, G01R 31/36

(54) **METHOD AND SYSTEM FOR VOLTAGE DETECTION**

(71) Applicant: Ficosa Automotive, S.L.U., 08028 Barcelona (ES)
(72) Inventor: MARSAL ROIG, Marc, Viladecavalls (Barcelona) (ES); FERNANDEZ COMESAÑA, Pablo, Viladecavalls (Barcelona) (ES)
(74) Representative: Bardehle Pagenberg S.L.

(57) **Abstract**

The present disclosure relates to a system for indicating a voltage level at a point of interest. The system comprises a first electrical circuit including the point of interest and a second electrical circuit which is electrically isolated from the first electrical circuit. The system further comprises a transmitter electrically connected to the first electrical circuit and a receiver electrically connected to the second electrical circuit. The second electrical circuit comprises a comparator configured to provide an output signal indicative of the voltage level at the point of interest based on a comparison between an input received from the receiver, and a reference voltage (V_{REF}). The present disclosure further relates to methods for determining a voltage level.

## Description

### TECHNICAL FIELD

The present disclosure relates to methods and systems for detecting or determining a voltage. More particularly, the present disclosure relates to methods and systems for detecting or determining a voltage level with respect to a specific threshold. The present disclosure particularly relates to the detection of a voltage in a first circuit working with a first voltage range, wherein the detection is carried in a second circuit working with a different voltage range. The present disclosure further relates to such methods and systems for detecting a voltage in an electric or hybrid vehicle, and more particularly in a high voltage system of a vehicle, e.g. a junction box of such a vehicle.

### BACKGROUND

The battery of an electric or hybrid vehicle can function as an energy storage element for powering an electrical motor and thus enabling the vehicle to move. A battery may include several cells, e.g. lithium-ion cells grouped into modules. Even though in the following reference will be made to an electric vehicle (EV), it should be understood that the present disclosure applies to hybrid vehicles as well.

In order to drive the vehicle, the battery may be connected to one or more electrical motors. The electrical motor or "traction motor" may drive a wheel axle. For example, a front wheel axle may be driven by a front traction motor, and a rear wheel axle may be driven by a rear traction motor. It is also possible for a single traction motor to drive a single axle.

The term "battery" within the present disclosure may be understood to refer to the battery or battery pack used for propulsion. A battery may operate at a voltage level of e.g. between 400 - 1.000 V and forms part of a high voltage circuit of an electric vehicle.

An electrical junction box comprises an enclosure housing electrical connections. Junction boxes generally serve the purpose of protecting these electrical connections. A junction box in a vehicle may e.g. be provided to electrically connect the electrodes of the battery (positive and negative or "cathode" and "anode") to inverter(s) of traction motors and/or to other electrical components or circuits. Such a junction box may generally comprise a housing with a plurality of busbars to conduct current. In the junction box, other electrical components such as fuses, different types of relays, and common mode filters may also be provided. The connections inside the junction box can selectively distribute power from the battery to other electrical systems, such as the aforementioned inverters.

It may be desirable to determine a voltage level in a high voltage circuit of a vehicle, e.g. at a location in the junction box. Such a determination of a voltage level may be used e.g. to detect a short circuit in the battery, a malfunction of an electrical contact or other.

In order to determine a voltage level in a high voltage circuit, it is known to provide a voltage measurement system in the high voltage circuit. Such a voltage measurement system however generally requires a separate low voltage power supply, which is disadvantageous, since it complicates the system and increases cost. It is known in the art to provide voltage measurement systems using microprocessor circuits. It is however desirable to avoid such microprocessor circuits to reduce cost, while maintaining or improving reliability.

In examples of the present disclosure, at least some of the aforementioned needs are addressed.

### SUMMARY

In an aspect of the disclosure, a system for indicating a voltage level at a point of interest is provided. The system comprises a first electrical circuit including the point of interest and a second electrical circuit and an isolation barrier for linking the first electrical circuit with the second electrical circuit and electrically isolating the second electrical circuit from the first electrical circuit. The isolation barrier further comprises a transmitter electrically connected to the first electrical circuit and a receiver electrically connected to the second electrical circuit. The transmitter is arranged such that a current level through the transmitter is indicative of the voltage level at the point of interest. The second electrical circuit comprises a comparator configured to provide an output signal indicative of the voltage level at the point of interest based at least on a comparison between an input received from the receiver and a reference voltage.

In accordance with this aspect, a system is provided that is capable of indicating a voltage level in a first circuit but which does not require a specific power supply for a measurement system in the first circuit. The voltage indication as provided by the first circuit and its processing also does not rely on a microprocessor. Rather, a cost-efficient and reliable hardware solution is provided.

The first electrical circuit may be a high voltage circuit of a vehicle, and the second electrical circuit may be a low voltage circuit of the vehicle. The high voltage circuit may herein be regarded as the electrical circuit of the vehicle including the battery pack, the buses and components connected to them (e.g. inverters, traction motors). The low voltage electrical circuit may herein be regarded as a secondary electrical circuit including auxiliary components of the car and their (low voltage) power supply. In examples, the voltage level may be measured at the junction box. I.e. the point of interest may be a specific point in the junction box.

The high voltage circuit is configured to operate at a higher voltage level than the low voltage circuit. In a non-limiting example, the high voltage circuit may operate at a voltage of 60V or higher, specifically 100V or higher, and in particular 400 - 1.000V, and the lower voltage circuit may operate at a voltage level of 40V or lower, specifically 16V or lower.

In some examples, the system may comprise an opto-coupler and the transmitter may be a light transmitter of an opto-coupler, and wherein the receiver may be a light receiver of the opto-coupler. The isolation barrier may comprise the opto-coupler.

The output signal of the comparator may be processed further to derive or determine the voltage level at the point of interest. In examples, the system may comprise a signal processing unit configured to receive the output signal of the comparator. The signal processing unit may provide a signal to an Electronic Control Unit (ECU) or may comprise the ECU. In some examples, the ECU may directly or indirectly (e.g. after further processing) receive the output signal of the comparator to determine the voltage level at the point of interest. Preferably, the ECU may be configured to determine whether or not the voltage level at the point of interest is equal to or exceeds a predefined or threshold value. The Electronic Control Unit may further be configured to determine proper functioning of a high voltage circuit of a vehicle and/or to derive a derive a malfunction based on the output of the hysteresis comparator.

Determining the voltage level at the point of interest may herein be regarded as encompassing an indication of a specific voltage level (i.e. a concrete value), but also to encompass a comparison of the voltage level with respect to a threshold value (i.e. higher or lower than the threshold value).

In examples, the comparator may be a hysteresis comparator to reduce or avoid hysteresis. A hysteresis comparator may herein be regarded as a comparator including a positive feedback to the comparator. A hysteresis comparator can avoid or reduce the influence of temperature changes.

In some examples, the system may further comprise a voltage reference module for providing the reference voltage to the comparator. Specifically, a low voltage battery supplies the voltage reference module, and wherein the voltage reference module is configured to provide a reference voltage which varies less than a voltage of the low voltage battery. The voltage reference module may be used to provide a more constant input to the hysteresis comparator. The comparison between the signal received through the opto-coupler (which is indicative of the voltage level to be determined) and the reference voltage can thus be more reliable and precise.

In some examples, the first electrical circuit may comprise a voltage divider including a first branch electrically connecting the point of interest with the opto-coupler and including a first resistance, and a second branch electrically connecting the opto-coupler with ground and including one or more impedances. Specifically, the second branch may comprise one or more Zener diodes. A suitable level for the Zener level of the diode(s) may be chosen with respect to a specific threshold value expected at the point of interest. The use of one or more Zener diodes can improve the precision of the detection of a voltage level above a threshold by reducing an error range.

In a further aspect of the present disclosure, a vehicle is provided comprising a system for indicating a voltage level according to any of the examples disclosed herein. The vehicle may be an electric vehicle or a hybrid vehicle.

In a further aspect of the present disclosure, a method for detecting a voltage level at a point of interest in a first electrical circuit is provided. The method comprises electrically connecting the point of interest with a transmitter such that a current received by the transmitter depends on the voltage level at the point of interest. The method further comprises receiving a transmitted signal in a second electrical circuit, the second electrical circuit being electrically isolated from the first electrical circuit. The electrical signal in the second electrical circuit is coupled to a first input of a comparator and the comparator receives a reference voltage as a second input. And the method further comprises the comparator providing an output signal dependent on a comparison between the first input and the second input.

### BRIEF DESCRIPTION OF THE DRAWINGS

Non-limiting examples of the present disclosure will be described in the following, with reference to the appended figures, in which:
Figure 1A schematically illustrates an example of a system for determining a voltage level;
Figure 1B schematically illustrates further details of the example of figure 1A;
Figure 1C schematically illustrates a voltage-current characteristic of a Zener diode; and
Figures 2A and 2B schematically illustrate how the use of a Zener diode, because of its specific characteristics, can improve the precision of the voltage measurement at the point of interest.

The figures refer to example implementations and are only be used as an aid for understanding the claimed subject matter, not for limiting it in any sense.

### DETAILED DESCRIPTION OF EXAMPLES

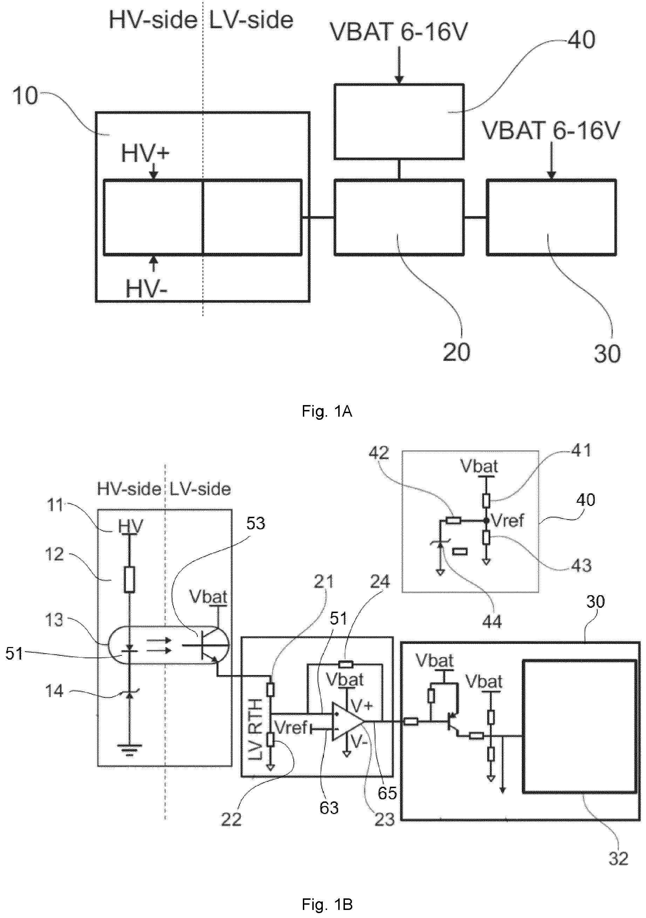

Figure 1A schematically illustrates an example of a system for determining or indicating a voltage level. The system may be part of an Electric Vehicle (EV). The system of this example comprises a high voltage (HV) side and a low voltage (LV) side. The HV side of the system may include a junction box connected to a traction battery.

In an aspect of the present disclosure, a voltage detection system is provided, which is configured to detect or otherwise determine a voltage level at a point of interest. Particularly in this example, the voltage detection system may be configured to measure or otherwise determine a voltage level of the first electrical circuit or high voltage (HV) side, for example, at the junction box. It should be clear that in other examples, the point of interest may be elsewhere, e.g. at an On-Board Charger or any other electrical device.

In particular, the system may be configured to determine whether a voltage level is above a voltage threshold. In some examples, the voltage threshold may be 60 V, but it will be clear that in other examples, other threshold values may be defined. In a further aspect of the present disclosure, a vehicle comprising a vehicle bodywork and further comprising a voltage detection system according to any of the examples herein is provided.

The HV side is electrically isolated from the LV side. Detection of the presence or absence of a voltage at the junction box occurs in box 10. A presence of a high voltage may indicate correct functioning in some examples, whereas the absence of the high voltage may be indicative of a problem or failure. In case of a correct functioning, certain functionalities may be enabled (e.g. charging, starting of engine or other), whereas certain functionalities may be disabled in case of a malfunction.

The output signal from the measurement of the voltage may result in input to a comparator 20 (more details of a particular example are provided with reference to figure 1b), particularly a hysteresis comparator. The comparator 20 may compare the received input with a voltage reference provided by voltage reference module 40. The output of the comparator may be that presence or absence of a voltage level above a threshold may be determined. This finding will be indicative of the voltage level at the HV side.

The output of the comparator may be provided to a signal processing unit 30. The signal processing unit may comprise or be connected to an ECU of the vehicle. The ECU of the vehicle may thus determine whether a voltage level is present at the point of interest of the first circuit (in this example in the junction box) or not, and particularly it may determine whether the voltage level at the junction box is above or below a predetermined threshold. The ECU may further send control signals in response to the determination e.g., in case of a problem, an alarm may be generated, a protective system may be activated, a functionality may be enabled or disabled based on the finding or other.

Figure 1B schematically illustrates further details of the example of figure 1A. As illustrated in figure 1B, a system for indicating a voltage level at a point of interest 11 is provided. The system comprises a first electrical circuit (in this case HV-side) including the point of interest 11. The system comprises a second electrical circuit (in this case LV-side) which is electrically isolated from the first electrical circuit.

The system comprises an isolation barrier for electrically isolating the HV-side from the LV-side. A transmitter may be arranged at the HV-side, and a receiver is arranged in the LV-side. A transmitter can be configured to generate a signal and transmit the signal without establishing an electrical connection with the receiver. The signal generated by the transmitter may in particular depend on the current provided to the transmitter.

The system in this example comprises an opto-coupler 13, which comprises a light transmitter 51 electrically connected to the first electrical circuit and a light receiver 53 electrically connected to the second electrical circuit. The opto-coupler may be powered by the second circuit, i.e., the LV-side. A low voltage battery may supply the opto-coupler. The light transmitter 51 may be or comprise a LED, and particularly a LED configured to transmit infrared light.

The first electrical circuit in this example is basically constituted as a voltage divider including a first branch electrically connecting the point of interest 11 with one side (the side of the light transmitter) of the opto-coupler 3, and a second branch electrically connecting the same side of the opto-coupler 3 with ground (GRD).

The first branch may comprise one or more resistors 12. The second branch may also comprise one or more impedances.

In this specific example, the second branch of the first circuit comprises one or more Zener diodes 14. The Zener voltage of the Zener diodes may be set at a suitable level in relation with the threshold value that is determined for the point of interest 11. In a specific example, the threshold value for the voltage to be detected may be 60V. In such an example, the Zener voltage of the Zener diode(s) 14 may be set e.g. around 40V.

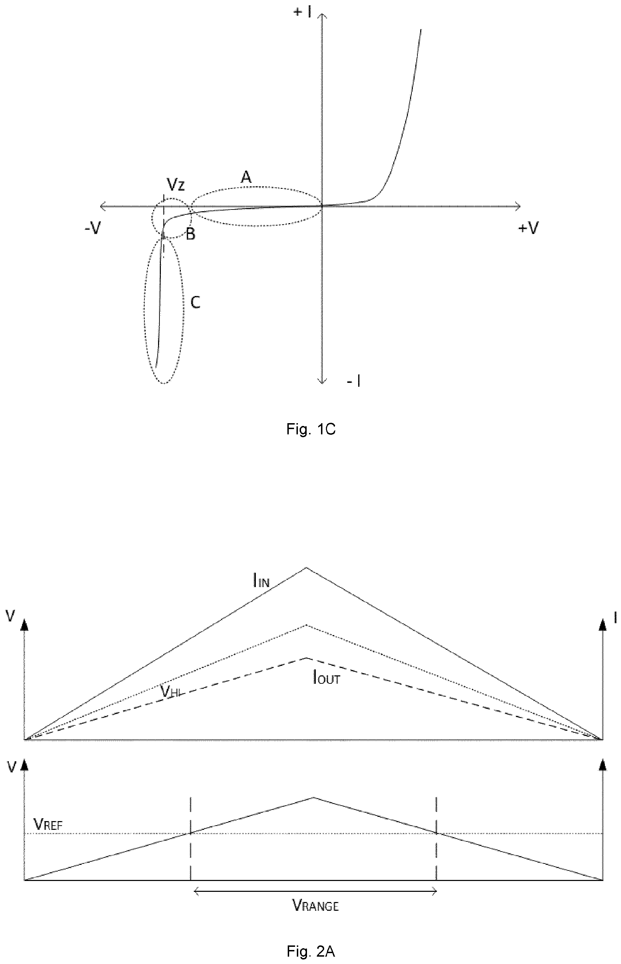

A Zener diode is a diode designed to reliably allow current to flow "backwards" (inverted polarity) when a certain set reverse voltage, known as the Zener voltage, is reached. A characteristic voltage-current curve for a Zener diode is illustrated in figure 1C.

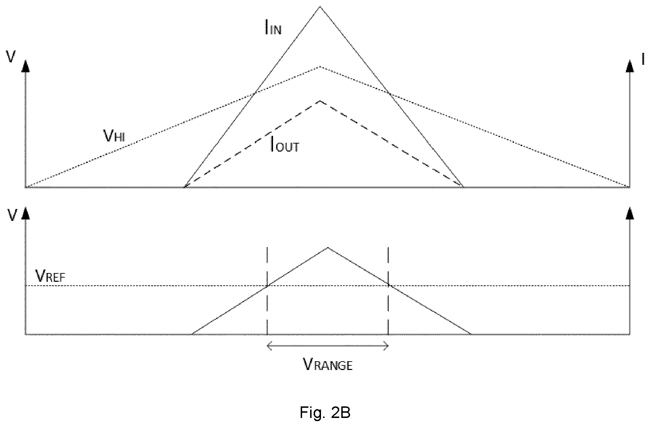

As illustrated in figure 1C, when the voltage at the point of interest is relatively low, the Zener diode 14 essentially blocks current flow in one direction (zone A). When the voltage at the point of interest is high (zone C), the Zener diode essentially functions as a classic resistance. At a voltage level around the Zener voltage (zone B), current passing through the diodes varies significantly e.g. exponentially with small increases of voltage. The use of one or more Zener diodes in the second branch of the voltage divider can reduce the operational range of the voltage applied to the light transmitter of the opto-coupler as will be illustrated herein with respect to figures 2A and 2B. Since the operational range is reduced, the precision of the voltage measurement can be improved.

A voltage level applied to the LED of the opto-coupler will depend on the voltage level at the point of interest 11. The voltage applied to the LED 51 will result in a current through the LED. The transmitted (infrared) light is received by a light receiver 53, specifically a photosensor. The light receiver 53 may be a phototransistor in this specific example. In other examples, the sensor can be a photoresistor, or e.g. a photodiode.

A current level through the light transmitter 51 of the opto-coupler is indicative of the voltage level at the point of interest. The amount of radiation (light) transmitted by the LED 51 and received by the phototransistor 53 may thus be directly dependent on the voltage level at the point of interest 11. The output signal or output voltage of the opto-coupler at the low voltage side will thus depend on the voltage detection at point of interest 11.

The values for the resistor(s) and Zener voltage may be chosen such that at the voltage threshold which is used for detection, the Zener diode is operating around the zone B of figure 1C

The second electrical circuit in this example comprises a comparator 20 configured to provide an output signal indicative of the voltage level at the point of interest based on a comparison between an input 61 received from the light receiver 53 of the opto-coupler 13, and another input 63: reference voltage V_{REF}.

In this example, a voltage divider is arranged between the light receiver 53 side of the optocoupler 13 and one of the inputs of the comparator 23. The voltage divider includes a first branch including a first resistance 21, and a second branch including a second resistance 22. The second resistance may be a thermal resistance RTH. The voltage supplied to the comparator 61 is arranged between the first and second branches. Since the voltage at the light receiving 53 side is directly dependent on the voltage level at the point of interest 11, also the input 61 for the comparator is directly dependent on the voltage level at the point of interest 11.

The comparator in this example further comprises a hysteresis resistor 24 and is configured as a hysteresis comparator.

In this example, a voltage reference module 40 is arranged for providing the second input, i.e. the reference voltage V_{REF}, to the hysteresis comparator 20. The low voltage battery may supply the voltage reference module. In examples, the low voltage battery may form part of the voltage reference module.

In this example, the voltage reference module 40 comprises a voltage divider including a first branch from the low voltage battery V_{BAT} to a reference and including a first resistance 41, and a second branch from the reference to ground (of the second circuit) including a second resistance 43. The voltage reference module further comprises a Zener diode 44 in a third branch between the reference and ground. The voltage V_{REF} at the reference point is provided as second input to the comparator.

The inclusion of the third branch with one or more Zener diodes may reduce fluctuation of the reference voltage when the voltage at the low voltage battery varies e.g. between 6 - 16V. In this particular example, the third branch may comprise an additional resistance 42.

The output signal of the opto-coupler is provided through resistor 21 as input for the comparator 23. The other input of the comparator that is provided is the reference voltage V_{REF} as provided by module 40. Based on the comparison between the signal received from the opto-coupler 13 and the reference voltage V_{REF}, the output of the hysteresis comparator may be indicative of a voltage level at point 11 above the predetermined threshold, and alternatively may be indicative of the voltage level at point 11 being below the predetermined threshold. In this particular example, the output of the comparator in case of a finding above the threshold is the voltage level of the low voltage battery. In the alternative, the output is 0V.

In this specific example, the system may further comprise a signal processing unit 30 configured to receive the output of the hysteresis comparator. The signal processing unit may include the ECU of the vehicle. In further examples, an output of the signal processing unit may be supplied, either directly or after further processing, to the ECU. Based on the signal received, the ECU may determine that the HV side is at an appropriate level or not.

In a specific example, the voltage level of the low voltage battery may vary. And an output of the signal processing unit 30 may depend on a voltage of the low voltage battery. Influence of the variations of the voltage of the low voltage battery may be reduced or avoided since the input to the signal processing unit is also related to the voltage of the low voltage battery.

The signal processing unit may be configured in a variety of ways depending on which (additional) information is to be extracted.

As herein explained, a method for detecting a voltage level at a point of interest in a first electrical circuit is provided. The method comprises: electrically connecting the point of interest with transmitter such that a current received by the transmitter depends on the voltage level at the point of interest. The method further comprises receiving the transmitted signal in the second electrical circuit, the second electrical circuit being electrically isolated from the first electrical circuit. The electrical signal in the second electrical circuit is coupled to a first input of a comparator and the comparator receives a reference voltage as a second input. The comparator provides an output signal dependent on a comparison between the first input and the second input.

The method may further comprise providing the output signal of the (hysteresis) comparator to an output circuit configured to determine the voltage level at the point of interest.

The received signal in the second electrical circuit, and the reference voltage are related to a voltage level of the low voltage battery. In this example, the output signal of the comparator is also related to the low voltage battery.

Figures 2A and 2B schematically illustrate how the use of a Zener diode, because of its specific characteristics, can improve the precision of the voltage measurement at the point of interest.

Figure 2A illustrates with V_{HI} a sweep voltage signal for a voltage in the HV-circuit, particularly at the point of interest. Figure 2A illustrates the current level I_{IN} at the light emitting side of the opto-coupler in case a classic resistor is provided in the second branch of the voltage divider, rather than a Zener diode. As voltage increases linearly, so does the current through the LED of the opto-coupler. The current at the light receiver side of the opto-coupler is illustrated as I_{OUT}.

In the lower half of figure 2A, a comparison is made between the voltage level input for the comparator and a voltage reference provided by the voltage reference module, which is herein assumed to be constant. The output of the comparator is "1" or positive when a voltage input is above the reference voltage. This may cover a certain a voltage range, indicated as V_{RANGE}. It is noted herein that the voltage range illustrated in the figure corresponds to a sweep signal including both an increasing voltage and a decreasing voltage. Different values may be obtained for different voltages at the low voltage battery, and for different operating temperatures, although the reference voltage will not or hardly be affected by such changes.

Figure 2B serves to compare the above situation with the situation in which the second branch of the voltage divider of the HV-circuit comprises a Zener diode 14. As long as the voltage over the Zener diode is below the Zener voltage, the Zener diode essentially blocks the current entirely. Above the Zener voltage, the current I_{IN} through the LED of the opto-coupler increases linearly. The current at the light receiver side of the opto-coupler is illustrated as I_{OUT} which shows the same pattern.

In the lower half of figure 2B, a comparison is made between the voltage level input for the comparator and a voltage reference provided by the voltage reference module, which is herein assumed to be constant. The output of the comparator is "1" or positive when a voltage input is above the reference voltage. This may cover a certain a voltage range, indicated as V_{RANGE}. It is noted herein that the voltage range illustrated in the figure corresponds to a sweep signal including both an increasing voltage and a decreasing voltage. Since the voltage range for detection is reduced with the use of a Zener diode, precision of the voltage detection may be improved in a corresponding manner.

Although only a number of examples have been disclosed herein, other alternatives, modifications, uses and/or equivalents thereof are possible. Furthermore, all possible combinations of the described examples are also covered. Thus, the scope of the present disclosure should not be limited by particular examples, but should be determined only by a fair reading of the claims that follow.

## Claims

1. A system for indicating a voltage level at a point of interest comprising:
a first electrical circuit including the point of interest;
a second electrical circuit;
an isolation barrier linking the first electrical circuit with the second electrical circuit and electrically isolating the first electrical circuit from the second electrical circuit;
the isolation barrier comprising a transmitter electrically connected to the first electrical circuit and a receiver electrically connected to the second electrical circuit, and wherein a current level through the transmitter is indicative of the voltage level at the point of interest, and wherein
the second electrical circuit comprises a comparator configured to provide an output signal indicative of the voltage level at the point of interest based at least on a comparison between an input received from the receiver and a reference voltage.

2. The system of claim 1, wherein the transmitter is a light transmitter of an opto-coupler, and wherein the receiver is a light receiver of the opto-coupler.

3. The system of claim 1 or 2, wherein the comparator is a hysteresis comparator.

4. The system of any of claims 1 - 3, further comprising a voltage reference module for providing the reference voltage to the comparator.

5. The system of claim 4, wherein a low voltage battery supplies the voltage reference module, and wherein the voltage reference module is configured to provide a reference voltage which varies less than a voltage of the low voltage battery.

6. The system of any of claims 1 to 5, wherein the voltage reference module comprises a voltage divider including a first branch from the low voltage battery to a reference and including a first resistance, and a second branch from the reference to ground including a second resistance, and further comprising a Zener diode in a third branch between the reference and ground, and optionally, wherein the third branch comprises an additional resistance.

7. The system of any of claims 1-6, wherein the first electrical circuit comprises a voltage divider including a first branch electrically connecting the point of interest with the transmitter and including a first resistor, and a second branch electrically connecting the transmitter with ground and comprising an impedance.

8. The system of claim 7, wherein the impedance of the second branch comprises a Zener diode.

9. The system of any of claims 1-8, further comprising a signal processing unit configured to receive the output signal of the comparator.

10. The system of any of claims 1 - 9, wherein the output of the comparator is provided to an Electronic Control Unit.

11. The system of claim 10, wherein the Electronic Control Unit is configured to determine whether a voltage level at the point of interest is above a voltage threshold or not.

12. The system of any of claims 1 - 11, wherein the first electrical circuit is a high voltage circuit, and the second electrical circuit is a low voltage circuit.

13. The system of any of claims 1 - 12, wherein the point of interest is in a junction box of the vehicle.

14. A method for detecting a voltage level at a point of interest in a first electrical circuit, the method comprising:
electrically connecting the point of interest with an input side of a transmitter such that a current received by the transmitter depends on the voltage level at the point of interest;
receiving a signal from the transmitter in a second electrical circuit, the second electrical circuit being electrically isolated from the first electrical circuit;
the voltage in the second electrical circuit being coupled to a first input of a hysteresis comparator and the hysteresis comparator receiving a reference voltage as a second input; and
the hysteresis comparator providing an output signal dependent on a comparison between the first input and the second input.

15. The method of claim 14, further comprising providing the output signal of the comparator to an output circuit configured to determine the voltage level at the point of interest.
